# EUROPÄISCHE PATENTANMELDUNG

(11) **EP 4 549 982 A2**
(43) Veröffentlichungstag der Anmeldung: **07.05.2025**
(21) Anmeldenummer: 25165253.3
(22) Anmeldetag: 29.12.2021
(51) Int. Cl.: G01R 33/422

(54) **VORHANG UND SCHIRMKABINE ZUR SCHIRMUNG EINES ELEKTROMAGNETISCHEN FELDS**

(62) Teilanmeldung aus: 21218036.8
(71) Anmelder: Siemens Healthineers AG, 91301 Forchheim (DE)
(72) Erfinder: Sukkau, Johann, 91074 Herzogenaurach (DE); Wullenweber, Michael, 79104 Freiburg (DE)
(74) Vertreter: Siemens Healthineers Patent Attorneys

(57) **Zusammenfassung**

Die Erfindung betrifft einen Vorhang (31) zur Schirmung eines elektromagnetischen Felds, aufweisend eine Mehrzahl von Streifenelementen (33), wobei ein erstes Streifenelement und ein zweites Streifenelement der Mehrzahl von Streifenelementen (33) eine elektrisch leitfähige Schicht (38) aufweisen und wobei die elektrisch leitfähige Schicht (38) des ersten Streifenelements in einer Schirmungskonfiguration des Vorhangs (31) elektrisch mit der elektrisch leitfähigen Schicht (38) des zweiten Streifenelements und/oder einem elektrischen Anschluss für ein Bezugspotenzial verbunden ist, wobei die Mehrzahl von Streifenelementen (33) veränderlich gegeneinander positionierbar sind. Ferner betrifft die Erfindung eine Schirmkabine mit einem erfindungsgemäßen Vorhang (31) und ein Magnetresonanzsystem mit einer erfindungsgemäßen Schirmkabine.

## Beschreibung

Die Magnetresonanztomografie ist ein bekanntes Bildgebungsverfahren, mit welchem Magnetresonanzbilder eines Inneren des Untersuchungsobjekts erzeugt werden können. Bei der Durchführung einer Magnetresonanzbildgebung wird das Untersuchungsobjekt üblicherweise in einem starken, statischen und homogenen Grundmagnetfeld (B0-Magnetfeld) einer Magnetresonanzvorrichtung positioniert. Das Grundmagnetfeld kann magnetische Feldstärken von 0,2 Tesla bis 7 Tesla aufweisen, sodass sich Kernspins des Untersuchungsobjekts entlang des Grundmagnetfeldes ausrichten. Um sogenannte Kernspinresonanzen auszulösen, werden hochfrequente Signale, sogenannte Anregungsimpulse (B1-Magnetfeld), in das Untersuchungsobjekt eingestrahlt. Jeder Anregungsimpuls bewirkt eine Abweichung einer Magnetisierung bestimmter Kernspins des Untersuchungsobjekts von dem Grundmagnetfeld um einen Betrag, welcher auch als Flipwinkel bekannt ist. Ein Anregungsimpuls kann dabei ein magnetisches Wechselfeld mit einer Frequenz aufweisen, welche der Larmorfrequenz bei der jeweiligen statischen Magnetfeldstärke entspricht. Die angeregten Kernspins können eine rotierende und abklingende Magnetisierung (Kernspinresonanz) aufweisen, welche sich mittels spezieller Antennen als Magnetresonanzsignal erfassen lässt. Zur räumlichen Kodierung der Kernspinresonanzen des Untersuchungsobjekts können dem Grundmagnetfeld magnetische Gradientenfelder überlagert werden.

Die empfangenen Magnetresonanzsignale werden typischerweise digitalisiert und als komplexe Werte in einer k-Raum-Matrix gespeichert. Diese k-Raum-Matrix kann als Grundlage für eine Rekonstruktion von Magnetresonanzbildern sowie eine Bestimmung von Spektroskopiedaten verwendet werden. Die Rekonstruktion eines Magnetresonanzbilds erfolgt typischerweise mittels einer mehrdimensionalen Fourier-Transformation der k-Raum-Matrix.

Zur Einhaltung von gesetzlichen Vorgaben, aber auch zur Gewährleistung einer möglichst hohen Bildqualität, werden Untersuchungsräume von Magnetresonanzsystemen üblicherweise mit einer Schirmung (z. B. ein Faraday'scher Käfig) ausgestattet. Diese Schirmung schützt das Magnetresonanzsystem, aber auch eine unmittelbare Umgebung des Untersuchungsraums, vor elektromagnetischen Feldern. Eine mögliche Implementierung umfasst ein Auskleiden von Wänden, Decken und Böden des Untersuchungsraums mit Edelstahlblechen. Zugänge zum Untersuchungsraum, wie z. B. Türen, werden entweder vollflächig mit Edelstahlblech ausgekleidet oder mit Edelstahlgitter und Glaselementen versehen (wenn eine Transparenz gewünscht ist). Ist die Tür zum Untersuchungsraum geöffnet, so ist die Schirmung wirkungslos und elektromagnetische Strahlung kann den Zugang zum Untersuchungsraum in beide Richtungen passieren. In diesem Fall ist eine Durchführung einer Magnetresonanzmessung üblicherweise untersagt, da sich elektromagnetische Felder aus der Umgebung des Untersuchungsraums negativ auf eine Qualität aufgenommener Bilddaten auswirken können. Gleichermaßen können Geräte in der Umgebung des Untersuchungsraums durch elektromagnetische Felder, welche von der Magnetresonanzvorrichtung emittiert werden, beeinträchtigt werden.

Aus Anwendersicht besteht jedoch ein Interesse, Arbeitsabläufe und/oder ausgewählte Magnetresonanzmessungen auch bei einer geöffneten Tür zum Untersuchungsraum durchführen zu können. Dadurch ließe sich eine Kommunikation zwischen einem Patienten und einem Nutzer des Magnetresonanzsystems, aber auch ein Vorbereiten des Magnetresonanzsystems und des Patienten für das Durchführen einer Magnetresonanzmessung, vereinfachen.

Es ist daher eine Aufgabe der Erfindung, einen Arbeitsablauf eines Nutzers eines Magnetresonanzsystems effizienter zu gestalten und/oder zu vereinfachen.

Diese Aufgabe wird durch die Gegenstände der unabhängigen Patentansprüche erfindungsgemäß gelöst. Vorteilhafte Ausführungsformen und zweckmäßige Weiterbildungen sind Gegenstand der Unteransprüche.

Der erfindungsgemäße Vorhang zur Schirmung eines elektromagnetischen Felds weist eine Mehrzahl von Streifenelementen auf. Vorzugsweise ist der Vorhang an einem Zugang bzw. Einlass zu einem Untersuchungsraum positioniert. Der Vorhang kann insbesondere an einer Tür, einem Wandausschnitt oder einer Öffnung einer Schirmkabine eines Magnetresonanzsystems positioniert sein.

In einer bevorzugten Ausführungsform ist der Vorhang derart positioniert, dass die Mehrzahl von Streifenelementen die Öffnung der Schirmkabine bzw. den Zugang zum Untersuchungsraum in einer Schirmungskonfiguration im Wesentlichen vollständig verschließen oder abdecken.

Die Schirmungskonfiguration kann insbesondere dadurch charakterisiert sein, dass einzelne Streifenelemente der Mehrzahl von Streifenelementen im Wesentlichen vertikal ausgerichtet nebeneinander angeordnet sind.

Ein erstes Streifenelement und ein zweites Streifenelement weisen eine elektrisch leitfähige Schicht auf. Die elektrisch leitfähige Schicht ist insbesondere flexibel gestaltet oder weist ein flexibles Material auf. Die elektrisch leitfähige Schicht kann derart flexibel ausgestaltet sein, dass sich das erste Streifenelement und/oder das zweite Streifenelement unter manueller Einwirkung eines Nutzers aus der Schirmungskonfiguration in eine Durchgangskonfiguration überführen lassen. Eine Durchgangskonfiguration kann durch eine beliebig geformte Öffnung, welche sich durch eine Verschiebung, eine Auslenkung und/oder eine relative Positionierung von einzelnen oder mehreren Streifenelementen der Mehrzahl von Streifenelementen ergibt, charakterisiert sein. Die in der Durchgangskonfiguration vorliegende Öffnung kann insbesondere ein Durchtreten des Nutzers aus dem Untersuchungsraum in einen angrenzenden Raum oder umgekehrt ermöglichen. Die elektrisch leitfähige Schicht kann insbesondere als eine dünne Folie, ein dünner Draht und/oder ein Drahtgeflecht aus einem leitfähigen Material ausgestaltet sein. Ein elektrisch leitfähiges Material kann insbesondere Metall oder Karbon darstellen.

In einer Ausführungsform ist die elektrisch leitfähige Schicht als eine Beschichtung, eine Folie, ein Draht, ein Drahtgeflecht, eine Anordnung von Metallgliedern und/oder eine Karbonmatrix ausgestaltet. Durch das Bereitstellen eines Drahts oder eines Drahtgeflechts lässt sich eine Masse oder ein Volumen der elektrisch leitfähigen Schicht auf vorteilhafte reduzieren oder optimieren. Dadurch kann ein Aufwand des Nutzers für das Überführen der Mehrzahl von Streifenelementen von der Schirmungskonfiguration in die Durchgangskonfiguration vorteilhaft reduziert werden.

Eine Anordnung von Metallgliedern kann insbesondere als Matrix oder Aneinanderreihung von Kettengliedern ausgestaltet sein. Die elektrisch leitfähige Schicht kann in diesem Fall durch ein massives Material der Kettenglieder bzw. Metallglieder konstituiert sein.

Ebenso lässt sich das Gewicht und/oder das Volumen der elektrisch leitfähigen Schicht auch mittels einer Karbonmatrix vorteilhaft reduzieren oder optimieren. Eine Karbonmatrix weist ferner den Vorteil auf, dass eine Richtung eines Stromflusses mittels einer Ausgestaltung der Karbonmatrix nach Wunsch angepasst werden kann. Beispielsweise kann die Karbonmatrix eine Mehrzahl von Karbonfasern aufweisen, wobei zumindest ein erster Teil von Karbonfasern im Wesentlichen orthogonal oder unter einem Winkel zu einem zweiten Teil von Karbonfasern ausgerichtet ist. Somit lässt sich ein Stromfluss entlang der Karbonfasern in wenigstens zwei oder mehr vorbestimmten Raumrichtungen bereitstellen.

Weiterhin kann die elektrisch leitfähige Schicht auch als eine Beschichtung und/oder eine eingebettete Folie ausgestaltet sein. Bei Verwendung einer Folie und/oder einer Beschichtung lassen sich Kosten und/oder ein Aufwand für eine Herstellung des Vorhangs auf vorteilhafte Weise reduzieren.

Die elektrisch leitfähige Schicht des ersten Streifenelements ist in einer Schirmungskonfiguration des Vorhangs elektrisch mit der elektrisch leitfähigen Schicht des zweiten Streifenelements und/oder einem elektrischen Anschluss für ein Bezugspotenzial verbunden. Eine elektrische Verbindung kann dabei insbesondere eine elektrisch leitende Verbindung darstellen. Vorzugsweise ist die Mehrzahl der Streifenelemente untereinander elektrisch verbunden. Die Mehrzahl von Streifenelementen kann derart untereinander elektrisch verbunden sein, dass ein Stromfluss entlang einer Richtung einer Haupterstreckung, aber auch unter einem Winkel zu der Haupterstreckungsrichtung, der Mehrzahl von Streifenelementen ermöglicht wird.

Eine Haupterstreckungsrichtung der Streifenelemente kann beispielsweise mit einer Richtung übereinstimmen, in welcher ein Streifenelement die größte Abmessung aufweist. Vorzugsweise ist die Mehrzahl von Streifenelementen in vertikaler Ausrichtung an dem Zugang zum Untersuchungsraum angeordnet. Die größte Abmessung eines Streifenelements kann somit im Wesentlichen mit einer Höhe der Öffnung oder der Tür der Schirmkabine übereinstimmen.

Das erste Streifenelement und das zweite Streifenelement können beispielsweise mittels eines Kontaktelements elektrisch miteinander verbunden sein. Es ist jedoch ebenso vorstellbar, dass das erste Streifenelement und das zweite Streifenelement mechanisch mit einem Halteelement verbunden sind. Das erste Streifenelement und das zweite Streifenelement können entsprechend über das Halteelement elektrisch miteinander und/oder mit einem Bezugspotenzial verbunden sein.

Es ist weiterhin vorstellbar, dass ein oder mehrere Streifenelemente der Mehrzahl von Streifenelementen elektrisch leitend mit einem Anschluss für ein Bezugspotenzial verbunden sind. Durch eine elektrische leitende Verbindung mit einem Anschluss für ein Bezugspotenzial ist die Mehrzahl von Streifenelementen imstande, ein elektrisches Potenzial bzw. einen durch ein elektromagnetisches Feld induzierten Strom abzuleiten.

Die Mehrzahl von Streifenelementen ist veränderlich gegeneinander positionierbar. Es ist vorstellbar, dass das erste Streifenelement und das zweite Streifenelement mechanisch und elektrisch voneinander trennbar sind. Beispielsweise können das erste Streifenelement und das zweite Streifenelement bei der Überführung des Vorhangs von der Schirmungskonfiguration in die Durchgangskonfiguration zumindest kurzfristig voneinander getrennt werden, um ein Passieren eines Nutzers zu ermöglichen. Es ist weiterhin vorstellbar, dass eine Schirmungswirkung des Vorhangs gegen elektromagnetische Felder reduziert ist, solange eine Anordnung der Mehrzahl von Streifenelementen von der Schirmungskonfiguration abweicht.

Das erste Streifenelement und das zweite Streifenelement können mechanisch unverbunden sein. Eine mechanische Unverbundenheit kann insbesondere bedeuten, dass das erste Streifenelement einen elektrischen Kontakt mit dem zweiten Streifenelement aufweist, aber weder kraftschlüssig, formschlüssig noch stoffschlüssig mit dem zweiten Streifenelement verbunden ist. Insbesondere können das erste Streifenelement und das zweite Streifenelement aneinander anliegen und/oder einander berühren, ohne sich wesentlich gegeneinander in einer relativen Bewegung einzuschränken.

Der Vorhang kann beispielsweise einstückig ausgestaltet sein. Dies kann bedeuten, dass die Mehrzahl von Streifenelementen mit dem Vorhang verwoben oder als Einschnitte in den Vorhang ausgestaltet sind. Alternativ kann der Vorhang auch ein Halteelement aufweisen, welches mechanisch mit der Mehrzahl von Streifenelementen verbunden ist.

Ein Streifenelement kann durch eine flache, längliche Struktur charakterisiert sein. Beispiele für geeignete Strukturen sind Bänder, Riemen, Streifen und dergleichen. Eine Längenabmessung (z. B. eine Länge entlang der Haupterstreckungsrichtung) eines Streifenelements kann eine Breitenabmessung des Streifenelements beispielsweise um einen Faktor zwischen 1,2 und 50 oder mehr übersteigen. Die Mehrzahl von Streifenelementen ist vorzugsweise in einem Zugangsbereich zu einem Untersuchungsraum, insbesondere in einem Wandausschnitt für eine Tür, angeordnet. Vorzugsweise entspricht die Längenabmessung eines Streifenelements etwa einer Höhe des Wandausschnitts. Die Breitenabmessung eines Streifenelements kann im Wesentlichen einem Quotienten aus einer Breite des Wandausschnitts und einer Gesamtanzahl der Mehrzahl von der Streifenelemente betragen. Selbstverständlich können sich einzelne Streifenelemente auch teilweise seitlich überlagern, sodass die Breitenabmessung eines Streifenelements den Wert des Quotienten der Breite des Wandausschnitts mit der Gesamtanzahl von Streifenelementen übersteigt. Eine Breite einer ersten Teilmenge von Streifenelementen kann mit einer Breite einer zweiten Teilmenge von Streifenelementen übereinstimmen oder von dieser abweichen.

Eine Schirmungswirkung des erfindungsgemäßen Vorhangs kann hauptsächlich durch Reflektion von elektromagnetischer Strahlung an der elektrisch leitfähigen Schicht bereitgestellt werden. Die elektrisch leitfähige Schicht des Vorhangs kann hierfür mobile Ladungsträger aufweisen, welche mit elektromagnetischen Feldern der Strahlung wechselwirken. Eine hohe elektrische Leitfähigkeit sowie eine elektrische leitende Verbindung mit einem Anschluss für ein Bezugspotenzial können hierbei vorteilhaft sein, sind jedoch nicht als zwingend erforderlich anzusehen. Die Schirmungswirkung kann weiterhin durch Absorption bereitgestellt werden. Beispielsweise können elektrische und/oder magnetische Dipole in oder an der elektrisch leitfähigen Schicht mit elektromagnetischen Feldern der elektromagnetischen Strahlung wechselwirken oder diese abschwächen. Es ist ebenso vorstellbar, dass die Schirmungswirkung durch Reflektion der elektromagnetischen Strahlung an einer Mehrzahl von Grenzschichten, wie z. B. Grenzschichten einer mehrlagigen oder mehrschichtigen Karbonmatrix, bereitgestellt wird. Durch den Skin-Effekt können Materialien mit einer Mehrzahl von Grenzschichten eine Effektivität der Schirmungswirkung signifikant gegenüber einlagigen Materialien bzw. bulk-Materialien erhöhen.

Durch das Bereitstellen eines erfindungsgemäßen Vorhangs kann ein Nutzer eines Magnetresonanzsystems effizienter zwischen dem Untersuchungsraum und einem angrenzenden Raum wechseln, ohne eine Schirmung des Untersuchungsraums übermäßig zu kompromittieren. Ein erfindungsgemäßer Vorhang kann ferner eine geringere Schalldämmung aufweisen als konventionelle Türen. Dadurch lässt sich eine Kommunikation zwischen einer ersten Person außerhalb des Untersuchungsraums und einer zweiten Person innerhalb des Untersuchungsraums vorteilhaft verbessern bzw. vereinfachen. Der erfindungsgemäße Vorhang kann somit eine Verbesserung und/oder Vereinfachung einer Interaktion der ersten Person mit der zweiten Person ermöglichen.

In einer Ausführungsform des erfindungsgemäßen Vorhangs weist die elektrisch leitfähige Schicht eine Schutzschicht auf, welche die elektrisch leitfähige Schicht zumindest teilweise umschließt, wobei die Schutzschicht dazu ausgebildet ist,
- einen Berührschutz zu der elektrisch leitfähigen Schicht bereitzustellen und/oder
- die elektrisch leitfähige Schicht vor einem äußeren Einfluss zu schützen.

Eine Schutzschicht kann insbesondere elektrisch-isolierende Eigenschaften aufweisen. Die Schutzschicht kann beispielsweise aus einem Material bestehen, welches eine geringe elektrische Leitfähigkeit aufweist. Es ist jedoch ebenso vorstellbar, dass die Schutzschicht eine geringe thermische Leitfähigkeit aufweist.

Die Schutzschicht kann die elektrisch leitfähige Schicht zumindest teilweise oder vollständig entlang der Haupterstreckungsrichtung der Mehrzahl von Streifenelementen umschließen. Die elektrisch leitfähige Schicht kann zumindest teilweise von der Schutzschicht umschlossen und/oder in diese eingebettet sein. Die Schutzschicht kann insbesondere als ein Mantel oder eine Beschichtung ausgestaltet sein.

Es ist vorstellbar, dass die Schutzschicht dazu ausgebildet ist, einen direkten Kontakt der elektrisch leitfähigen Schicht und einer Hautoberfläche des Nutzers zu verhindern. Dadurch kann eine Wahrscheinlichkeit einer Übertragung von Fettsäuren auf der Hautoberfläche des Nutzers auf die elektrisch leitfähige Schicht, welche zu einer Korrosion der elektrisch leitfähigen Schicht führen kann, reduziert werden. Ein äußerer Einfluss kann demnach ein Kontakt mit dem Nutzer darstellen. Es ist aber ebenso vorstellbar, dass ein äußerer Einfluss ein Kontakt mit Feuchtigkeit, Schmutz, Staub und/oder einer mechanischen Belastung umfasst. Eine mechanische Belastung kann insbesondere durch eine mechanische Interaktion des Nutzers mit dem Vorhang gekennzeichnet sein. Eine solche mechanische Interaktion kann beispielsweise bei dem Überführen des Vorhangs von der Schirmungskonfiguration in die Durchgangskonfiguration und umgekehrt auftreten.

Die Schutzschicht ist vorzugsweise aus einem flexiblen Material gefertigt, um das Überführen des Vorhangs von der Schirmungskonfiguration in die Durchgangskonfiguration zu ermöglichen. Beispiele für flexible Materialien mit geeigneten Eigenschaften sind Kunststoffe, wie z. B. Polyethen, Polyamid, Polyester und Polyurethan. Neben Kunststoffen sind auch Materialien auf natürlicher Basis, wie z. B. Baumwolle oder Hanffasern, und diverse Komposit-Materialien vorstellbar.

In einer bevorzugten Ausführungsform weist die Schutzschicht eine Aussparung oder einen Spalt auf, welcher einen elektrischen Kontakt der elektrisch leitfähigen Schicht des ersten Streifenelements mit der elektrisch leitfähigen Schicht des zweiten Streifenelements ermöglicht. Ein solcher Kontakt kann beispielsweise mittels eines Kontaktelements bereitgestellt werden, welches die Schutzschicht durchbricht.

Durch das Bereitstellen einer Schutzschicht lässt sich eine Lebensdauer der Mehrzahl von Streifenelementen auf vorteilhafte Weise verlängern. Ferner lassen sich unerwünschte äußere Einflüsse auf die elektrisch leitfähige Schicht durch den Nutzer und/oder die Umgebung mittels der Schutzschicht auf vorteilhafte Weise reduzieren oder vermeiden.

In einer weiteren Ausführungsform des erfindungsgemäßen Vorhangs weisen die Mehrzahl von Streifenelementen und/oder die Schutzschicht ein flexibles Material auf, welches dazu ausgebildet ist, bei einem relativen Positionieren des ersten Streifenelements gegenüber dem zweiten Streifenelement reversibel verformt zu werden.

Die Schutzschicht kann beispielsweise eines der oben genannten Materialien aufweisen. Vorzugsweise ist die Schutzschicht derart beschaffen, dass der Vorhang in Abhängigkeit der Erdanziehungskraft eigenständig von der Durchgangskonfiguration in die Schirmungskonfiguration zurückkehrt. Beispielsweise kann die Schutzschicht derart flexibel ausgestaltet sein, dass das erste Streifenelement in Abhängigkeit der Erdanziehungskraft in eine Ausgangskonfiguration zurückkehrt, welche durch eine im Wesentlichen planare Erstreckung des ersten Streifenelements und/oder eine im Wesentlichen parallele Ausrichtung zu dem zweiten Streifenelement und/oder einem weiteren Streifenelement charakterisiert ist. Es ist jedoch ebenso vorstellbar, dass das Material der Schutzschicht ein Formgedächtnis aufweist. Beispielsweise kann das Formgedächtnis derart ausgestaltet sein, dass die Mehrzahl von Streifenelementen bestrebt ist, in die Schirmungskonfiguration zurückzukehren.

Die Mehrzahl von Streifenelementen kann beispielsweise Metallglieder aufweisen, welche relativ zueinander positionierbar sind und somit eine reversible Verformung ermöglichen. Es ist jedoch ebenso vorstellbar, dass die Mehrzahl von Streifenelementen dünne Drähte oder Fasern aus Metall oder Karbon aufweisen, welche sich reversibel verformen lassen. Solche dünnen Drähte oder Fasern können insbesondere in einem Gewebe, einem Geflecht, aber auch einer Matrix angeordnet sein.

Es ist weiterhin vorstellbar, dass das erste Streifenelement und/oder das zweite Streifenelement an einer einem Boden des Untersuchungsraums zugewandten Seite ein Gewicht bzw. eine Beschwerung aufweisen. Das Gewicht kann insbesondere dazu ausgebildet sein, eine Wirkung der Erdanziehungskraft auf das erste Streifenelement und/oder das zweite Streifenelement zu verstärken bzw. eine Richtung der Erdanziehung orientierte Kraft auf das erste Streifenelement und/oder das zweite Streifenelement auszuüben.

Durch das Bereitstellen eines Vorhangs mit einer Mehrzahl von flexiblen Streifenelementen lässt sich ein Zugang des Nutzers zu dem Untersuchungsraum und/oder ein Verlassen des Untersuchungsraums vorteilhaft vereinfachen.

In einer bevorzugten Ausführungsform des erfindungsgemäßen Vorhangs ist die elektrisch leitfähige Schicht des ersten Streifenelements mittels eines Kontaktelements elektrisch mit der elektrisch leitfähigen Schicht des zweiten Streifenelements und/oder dem Anschluss für das Bezugspotenzial verbunden.

Ein Kontaktelement weist vorzugsweise ein Material mit einer hohen elektrischen Leitfähigkeit auf. Beispielsweise kann das Kontaktelement aus Kupfer, Aluminium, Silber oder Gold gefertigt sein. Es ist ebenso vorstellbar, dass das Kontaktelement ein Material mit einer hohen elektrischen Leitfähigkeit aufweist und/oder mit einem solchen Material beschichtet ist.

Das Kontaktelement kann dazu ausgebildet sein, das erste Streifenelement und das zweite Streifenelement entlang der Haupterstreckungsrichtung des ersten Streifenelements und des zweiten Streifenelements kontinuierlich oder in diskreten Abständen elektrisch miteinander zu verbinden. Mittels der elektrischen Verbindung des ersten Streifenelements mit dem zweiten Streifenelement kann insbesondere eine elektrische Quervernetzung des Vorhangs bereitgestellt werden. Es ist vorstellbar, dass die elektrische Quervernetzung des Vorhangs ein Leiten eines elektrischen Stroms in einer Richtung, welche unter einem Winkel zu der Haupterstreckungsrichtung des ersten Streifenelements ausgerichtet ist, ermöglicht. Ein solcher Winkel kann beispielsweise zwischen 30 und 160° betragen. Es ist jedoch ebenso vorstellbar, dass der Winkel kleiner als 30° und/oder größer als 160° ist.

In einer Ausführungsform ist das Kontaktelement mechanisch mit der elektrisch leitfähigen Schicht verbunden. Die mechanische Verbindung zwischen dem Kontaktelement und der elektrisch leitfähigen Schicht kann als kraftschlüssige, als formschlüssige und/oder als stoffschlüssige Verbindung ausgestaltet sein. Das Kontaktelement kann insbesondere durch Löten, Klemmen und/oder Verschrauben mit der elektrisch leitfähigen Schicht eines Streifenelements verbunden sein.

In einer alternativen Ausführungsform ist das Kontaktelement als ein Teil oder ein Abschnitt der elektrisch leitfähigen Schicht ausgestaltet. Das Kontaktelement kann insbesondere aus der Schutzschicht eines Streifenelements hervorragen, sodass ein elektrischer Kontakt mit einem Kontaktelement eines weiteren Streifenelements ermöglicht wird.

Vorzugsweise weist das erste Streifenelement ein erstes Kontaktelement auf. Das zweite Streifenelement kann dementsprechend ein zweites Kontaktelement aufweisen. Es ist vorstellbar, dass das erste Kontaktelement und das zweite Kontaktelement einander in einer Schirmungskonfiguration des Vorhangs berühren und/oder elektrisch miteinander verbunden sind. Der elektrische Kontakt zwischen dem ersten Kontaktelement und dem zweiten Kontaktelement kann durch das Überführen des Vorhangs von der Schirmungskonfiguration in die Durchgangskonfiguration aufgehoben werden. Gleichermaßen kann der elektrische Kontakt zwischen dem ersten Kontaktelement und dem zweiten Kontaktelement bei Rückstellung des Vorhangs in die Schirmungskonfiguration wieder hergestellt werden.

In einer Ausführungsform ist das Kontaktelement als ein Kamm, eine Bürste ein Geflecht und/oder ein Gewebe ausgestaltet. Das erste Kontaktelement kann insbesondere eine Mehrzahl von elektrischen Leitern aufweisen, welche einen elektrischen Kontakt mit einer Mehrzahl von elektrischen Leitern des zweiten Kontaktelements aufweisen, wenn sich der Vorhang in der Schirmungskonfiguration befindet. Es ist weiterhin vorstellbar, dass die Mehrzahl von elektrischen Leitern des ersten Kontaktelements mit der Mehrzahl von elektrischen Leitern des zweiten Kontaktelements zumindest teilweise mechanisch eingreift, wenn sich der Vorhang in der Schirmungskonfiguration befindet. Die elektrischen Leiter können beispielsweise als Drähte, Litzen, Plättchen und/oder Zinken ausgebildet sein. Die elektrischen Leitern können in einer im Wesentlichen zweidimensionalen Weise entlang der Hauterstreckungsrichtung des ersten Streifenelements und des zweiten Streifenelements angeordnet sein. Die elektrischen Leiter können aber auch in Form eines Gewebes und/oder eines Geflechts vorliegen.

In einer Ausführungsform ist die elektrisch leitfähige Schicht ein Karbongewebe und das Kontaktelement ein Teil bzw. Abschnitt des Karbongewebes. Das Kontaktelement kann dabei insbesondere ein aus einer Schutzschicht eines Streifenelements hervorgeführter Abschnitt des Karbongewebes darstellen.

Weiterhin kann das Kontaktelement als eine Kante einer elektrisch leitfähigen Folie oder der elektrisch leitfähigen Schicht ausgestaltet sein. Das Kontaktelement kann insbesondere ein aus einer Schutzschicht eines Streifenelements herausgeführter Abschnitt der elektrisch leitfähigen Schicht darstellen. Die Kante der elektrisch leitfähigen Folie oder der elektrisch leitfähigen Schicht kann eine im Wesentlichen geradlinige Kontur aufweisen, welche einen annähernd kontinuierlichen elektrischen Kontakt mit Kontaktelementen benachbarter Streifenelemente und/oder dem Anschluss für das Bezugspotenzial bereitstellt.

Es ist ebenso vorstellbar, dass die elektrischen Leiter mehrlagig oder überlappend angeordnet sind. Das Kontaktelement kann dabei im Wesentlichen einer Bürste entsprechen.

In einer Ausführungsform weist das Kontaktelement eine Beschichtung auf, welche dazu ausgebildet ist, eine chemische und/oder mechanische Belastung des Kontaktelements in Abhängigkeit eines äußeren Einflusses zu reduzieren oder zu verhindern. Die Beschichtung kann insbesondere eine hohe chemische und/oder mechanische Beständigkeit aufweisen, um eine Korrosion und/oder einen mechanischen Abrieb zu reduzieren oder zu vermeiden. Mögliche Beispiele sind metallische Beschichtungen aus Gold, Chrom, aber auch keramische Beschichtungen (z. B. mit Metallpartikeln versetzt), welche eine ausreichende elektrische Leitfähigkeit aufweisen.

Durch das Bereitstellen eines Kontaktelements lässt sich ein elektrischer Kontakt zwischen der elektrisch leitfähigen Schicht des ersten Streifenelements und der elektrisch leitfähigen Schicht des zweiten Streifenelements auf besonders einfache Weise realisieren. Ferner kann der elektrische Kontakt zwischen der elektrisch leitfähigen Schicht des ersten Streifenelements und des zweiten Streifenelements mittels des Kontaktelements auf vorteilhafte Weise reversibel lösbar ausgestaltet werden, sodass ein widerholendes Wechsels zwischen Schirmungskonfiguration und Durchgangskonfiguration ermöglicht wird.

In einer Ausführungsform umfasst der erfindungsgemäße Vorhang ein Halteelement, welches mechanisch mit dem ersten Streifenelement und dem zweiten Streifenelement verbunden ist und dazu ausgebildet ist, das erste Streifenelement und das zweite Streifenelement in der Schirmungskonfiguration an einer Öffnung zu einem Untersuchungsraum zu halten.

Das erste Streifenelement und das zweite Streifenelement können auf beliebige Weise mechanisch mit dem Halteelement verbunden sein. Vorzugsweise weist das Halteelement ein Bezugspotenzial auf und/oder ist elektrisch mit einem Bezugspotenzial verbunden. Die mechanische Verbindung zwischen dem Halteelement und dem ersten Streifenelement bzw. dem zweiten Streifenelement kann ferner eine elektrisch leitfähige Verbindung umfassen. Es ist vorstellbar, dass die mechanische Verbindung zwischen dem Halteelement und dem ersten Streifenelement bzw. dem zweiten Streifenelement als eine formschlüssige, eine kraftschlüssige und/oder eine stoffschlüssige Verbindung ausgeführt ist.

Die Öffnung des Untersuchungsraums kann gemäß einer unten beschriebenen Ausführungsform ausgestaltet sein. Vorzugsweise deckt die Mehrzahl der Streifenelement eine Fläche, welche durch die Öffnung des Untersuchungsraums definiert ist, vollständig ab.

In einer Ausführungsform des erfindungsgemäßen Vorhangs ist das Halteelement im Wesentlichen horizontal ausgerichtet und weist eine geschwungene Form auf. Vorzugsweise ist das Halteelement im Wesentlichen horizontal oder parallel zu einem Boden und/oder einer Decke des Untersuchungsraums ausgerichtet. Dadurch kann die Mehrzahl von Streifenelement im Wesentlichen identische Längenabmessungen aufweisen. Es ist ebenso vorstellbar, dass durch die im Wesentlichen horizontale Ausrichtung des Halteelements ein gleichmäßiger Kontakt der Mehrzahl von Streifenelementen mit einem Boden des Untersuchungsraums und/oder einer Bodenleiste über eine gesamte Breite des Zugangs zu dem Untersuchungsraum bereitgestellt wird.

Eine geschwungene Form des Halteelements kann beispielsweise durch eine Bogenform, eine Trichterform, eine Sanduhrform oder dergleichen charakterisiert sein. Es ist ebenso vorstellbar, dass die geschwungene Form des Halteelements durch eine Funktion charakterisiert ist, welche einen oder mehrere Wendepunkte aufweist.

Der Vorhang weist in der Schirmungskonfiguration eine geschwungene Querschnittskontur auf. Es ist vorstellbar, dass die geschwungene Form des Halteelements die Querschnittskontur des Vorhangs beeinflusst oder vorgibt. Beispielsweise kann die Querschnittskontur des Vorhangs entlang einer Schnittebene, welche im Wesentlichen horizontal oder parallel zu dem Boden und/oder der Decke des Untersuchungsraums ausgerichtet ist, mit einer Querschnittsform des Halteelements übereinstimmen. Vorzugsweise ist das Halteelements derart geformt, dass eine Kontaktfläche von zumindest zwei aneinander angrenzenden Streifenelementen entlang der Haupterstreckungsrichtung vergrößert wird. Es ist insbesondere vorstellbar, dass das erste Streifenelement und das zweite Streifenelement durch die mechanische Verbindung mit dem Halteelement unter einem Winkel zueinander angeordnet sind. Dies kann bedeuten, dass horizontale Querschnittssegmente des ersten Streifenelements und des zweiten Streifenelements nicht-parallel zueinander angeordnet sind. Die Überlappungsfläche kann ein oder mehrere Kontaktelemente gemäß einer oben beschriebenen Ausführungsform aufweisen oder als ein solches Kontaktelement ausgestaltet sein.

Durch Bereitstellen eines Halteelements mit einer geschwungenen Form lässt sich eine Überlappungsfläche und somit eine elektrische Kontaktfläche zwischen Streifenelementen des Vorhangs vorteilhaft vergrößern. Insbesondere kann aufgrund der geschwungenen Form des Halteelements ein Überführen des Vorhangs von der Schirmungskonfiguration in die Durchgangskonfiguration im Vergleich zu einer parallelen Anordnung der Mehrzahl von Streifenelemente auf vorteilhafte Weise vereinfacht werden.

In einer weiteren Ausführungsform weist der erfindungsgemäße Vorhang einen elektrischen Kontakt zu dem Bezugspotenzial auf. Es ist vorstellbar, dass das Halteelement und/oder ein Rahmenelement des Vorhangs elektrisch mit dem Bezugspotenzial verbunden sind. Ein Rahmenelement kann beispielsweise als ein elektrischer Leiter und/oder ein Kontaktelement ausgestaltet sein, welches bei Vorliegen der Schirmungskonfiguration des Vorhangs elektrisch mit einem Streifenelement, insbesondere einem äußersten Streifenelement, der Mehrzahl von Streifenelementen verbunden ist. Beispielsweise kann das Rahmenelement an einer vertikalen Kante des Wandausschnitts des Zugangs angeordnet sein. Es ist aber ebenso vorstellbar, dass das Rahmenelement an einer horizontalen Kante und/oder einem horizontalen Abschnitt des Zugangs oder Wandausschnitts angeordnet ist. Das Rahmenelement kann ferner als eine Bodenleiste ausgestaltet sein, welche dazu ausgebildet ist, einen elektrischen Kontakt der Mehrzahl von Streifenelementen in einer Bodennähe bereitzustellen. Es ist weiterhin vorstellbar, dass das Rahmenelement zumindest einen Teil der Öffnung der Schirmkabine entlang einer Innenkante der Öffnung einfasst.

Der Vorhang ist dazu ausgebildet, einer Wirkung des elektromagnetischen Felds durch Ermöglichen eines Ausgleichstroms mit dem Bezugspotenzial entgegenzuwirken. Beispielsweise kann die elektrisch leitfähige Schicht der Mehrzahl von Streifenelemente dazu ausgebildet sein, ein Auftreten von Eddy-Wirbelströmen in Abhängigkeit einer Wirkung eines ersten elektromagnetischen Felds zu ermöglichen. Diese Eddy-Wirbelströme können ein der Wirkung des ersten elektromagnetischen Felds entgegengerichtetes zweites elektromagnetisches Feld erzeugen. Die Wirkungen des ersten elektromagnetischen Felds und des zweiten elektromagnetischen Felds können sich zumindest lokal gegenseitig aufheben, sodass eine Schirmungswirkung bereitgestellt wird. Die elektrisch leitfähige Schicht ist insbesondere dazu ausgebildet, auftretende oder induzierte elektrische Ströme und/oder Potenziale mittels eines elektrischen Kontakts zu dem Halteelement, dem Rahmenelement und/oder der Bodenleiste abzuleiten.

In einer weiteren Ausführungsform des erfindungsgemäßen Vorhangs ist das erste Streifenelement elektrisch mit einem Rahmenelement und/oder einer Bodenleiste verbunden, wobei das Rahmenelement und/oder die Bodenleiste elektrisch mit dem Bezugspotenzial verbunden sind und wobei der Vorhang dazu ausgebildet ist, einen elektrischen Strom an das Rahmenelement und/oder die Bodenleiste abzuleiten. Es ist ebenso vorstellbar, dass neben oder anstelle des ersten Streifenelements das zweite Streifenelement und/oder ein weiteres Streifenelement elektrisch mit einem Rahmenelement und/oder einer Bodenleiste verbunden ist.

Durch das Bereitstellen eines elektrischen Kontakts zwischen der elektrisch leitfähigen Schicht der Streifenelemente und dem Rahmenelement bzw. der Bodenleiste lässt sich ein elektrischer Strom auf vorteilhafte Weise an eine nächstliegende Struktur mit einem Bezugspotenzial ableiten. Dadurch lässt sich ein Entstehen und/oder ein Halten von elektrischen Potenzialen in der elektrisch leitfähigen Schicht auf vorteilhafte Weise vermeiden. Weiterhin lässt sich ein Durchtreten von elektromagnetischen Feldern mittels eines Bereitstellens eines elektrischen Kontakts der elektrisch leitfähigen Schicht der Mehrzahl von Streifenelementen mit dem Halteelement, dem Rahmenelement und/oder der Bodenleiste auf vorteilhafte Weise vermeiden.

Die erfindungsgemäße Schirmkabine für eine Magnetresonanzvorrichtung weist eine Öffnung und einen Vorhang zur Schirmung eines elektromagnetischen Felds auf. Eine Geometrie der Schirmkabine kann im Wesentlichen mit einer Geometrie des Untersuchungsraums übereinstimmen. Es ist insbesondere vorstellbar, dass die Schirmkabine durch eine Innenfläche des Untersuchungsraums definiert ist oder von dieser bestimmt wird. Die Öffnung der Schirmkabine kann beispielsweise den Zugang bzw. Einlass zu dem Untersuchungsraum darstellen.

Der Vorhang umfasst eine Mehrzahl von Streifenelementen, wobei ein erstes Streifenelement und ein zweites Streifenelement der Mehrzahl von Streifenelementen eine elektrisch leitfähige Schicht aufweisen und wobei die elektrisch leitfähige Schicht des ersten Streifenelements in einer Schirmungskonfiguration des Vorhangs elektrisch mit einer elektrisch leitfähigen Schicht des zweiten Streifenelements der Mehrzahl von Streifenelementen und/oder mit einem Bezugspotenzial verbunden ist. Die Mehrzahl von Streifenelementen ist entlang einer Haupterstreckungsrichtung veränderlich gegeneinander positionierbar, wobei der Vorhang an der Öffnung der Schirmkabine angeordnet ist und dazu ausgebildet ist, einen Zugang zu der Schirmkabine zu ermöglichen.

Es ist vorstellbar, dass der Vorhang gemäß einer oben beschriebenen Ausführungsform manuell durch einen Nutzer von der Schirmungskonfiguration in die Durchgangskonfiguration überführbar ist. Der Nutzer kann somit effizient und/oder mit einem geringen Aufwand zwischen dem Untersuchungsraum und einem angrenzenden Raum wechseln. Ein angrenzender Raum kann insbesondere ein Kontrollraum für die Magnetresonanzvorrichtung darstellen.

Die erfindungsgemäße Schirmkabine teilt die Vorteile des erfindungsgemäßen Vorhangs gemäß einer oben beschriebenen Ausführungsform.

In einer bevorzugten Ausführungsform weist die Schirmkabine zumindest einen Sensor auf, welcher dazu ausgebildet ist, ein ordnungsgemäßes Vorliegen des Vorhangs in der Schirmungskonfiguration zu ermitteln.

Der zumindest eine Sensor kann auf einem beliebigen Messprinzip beruhen. Das Messprinzip des zumindest einen Sensors kann insbesondere dazu geeignet sein, eine geometrische Anordnung der Mehrzahl von Streifenelementen und/oder eine elektrische Eigenschaft der elektrisch leitfähigen Schicht der Mehrzahl von Streifenelementen zu ermitteln und/oder zu quantifizieren. Der zumindest eine Sensor kann beispielsweise als eine 2D Kamera, eine 3D Kamera, eine Infrarotkamera oder dergleichen ausgestaltet sein, welche dazu ausgebildet ist, Bilddaten von dem Vorhang zu erfassen. Die erfassten Bilddaten können anschließend von einer Recheneinheit verarbeitet werden, um ein Abweichen einer aktuellen Konfiguration des Vorhangs von der Schirmungskonfiguration zu ermitteln und/oder zu quantifizieren. Hierfür kann insbesondere eine Kamera verwendet werden, welche bereits für andere Arbeitsabläufe in dem Untersuchungsraum und/oder dem Kontrollraum genutzt wird. Dadurch lassen sich zusätzliche Kosten für den zumindest einen Sensor vorteilhaft reduzieren.

Der zumindest eine Sensor ist dazu ausgebildet, ein Signal auszugeben, welches eine Information über das Vorliegen des Vorhangs in der Schirmungskonfiguration enthält. Ein solches Signal kann beispielsweise einen Hinweis auf ein Vorliegen der Mehrzahl von Streifenelementen in der Schirmungskonfiguration, eine relative Anordnung der Mehrzahl von Streifenelementen und/oder eine elektrische Eigenschaft der elektrisch leifähigen Schicht der Mehrzahl von Streifenelementen umfassen. Das Signal des zumindest einen Sensors kann insbesondere ein digitales Signal oder ein analoges Signal darstellen. Durch das Bereitstellen zumindest eines Sensors lässt sich eine aufwändige Prüfung des Vorhangs durch den Nutzer auf vorteilhafte Weise vermeiden.

In einer Ausführungsform ist der zumindest eine Sensor als ein Widerstandssensor ausgestaltet ist, welcher dazu ausgebildet ist, einen Widerstand, insbesondere einen Flächenwiderstand, der elektrisch leitfähigen Schicht der Mehrzahl von Streifenelementen zu ermitteln.

Es ist vorstellbar, dass die erfindungsgemäße Schirmkabine einen ersten Widerstandssensor aufweist, welcher dazu ausgebildet ist, den Widerstand der elektrisch leitfähigen Schicht der Mehrzahl von Streifenelementen entlang einer vorbestimmten Bezugsstrecke entlang der Mehrzahl von Streifenelementen zu ermitteln. Die vorbestimmte Bezugsstrecke kann beispielsweise eine gesamte Breite der Öffnung der Schirmkabine von einem Rahmenelement zu einem gegenüberliegenden Rahmenelement umfassen. Es ist ebenso vorstellbar, dass die vorbestimmte Bezugsstrecke eine gesamte Höhe der Öffnung der Schirmkabine von dem Halteelement zu der Bodenleiste umfasst. Die erfindungsgemäße Schirmkabine kann weiterhin einen zweiten Widerstandssensor, einen dritten Widerstandssensor, einen vierten Widerstandssensor und/oder einen weiteren Widerstandssensor aufweisen, welche dazu ausgebildet sind, den Widerstand der elektrisch leitfähigen Schicht entlang unterschiedlicher Bezugsstrecken zur ermitteln.

Der Widerstandssensor kann insbesondere eine Messanordnung umfassen, welche dazu ausgebildet ist, einen Flächenwiderstand der elektrisch leitfähigen Schicht der Mehrzahl von Streifenelementen zu ermitteln. Beispielsweise kann die Messanordnung dazu ausgebildet sein, eine vier-Punkt-Messung und/oder eine Van-der-Pauw-Messung durchzuführen. Daneben sind selbstverständlich auch andere Messmethoden zur Erfassung einer elektrischen Eigenschaft der elektrisch leitfähigen Schicht vorstellbar.

Mittels eines Widerstandssensors lässt sich ein Vorliegen des Vorhangs in der Schirmungskonfiguration auf vorteilhafte Weise in Abhängigkeit des elektrischen Widerstands der elektrisch leitfähigen Schicht bestimmen. Widerstandssensoren stellen eine besonders einfach zu implementierende und/oder kostengünstige Möglichkeit zur Überwachung der Schirmungskonfiguration des Vorhangs bereit.

In einer weiteren Ausführungsform der erfindungsgemäßen Schirmkabine ist der zumindest eine Sensor als ein optischer Sensor ausgestaltet, welcher dazu ausgebildet ist, ein Abweichen des Vorhangs von der Schirmungskonfiguration zu ermitteln.

Der optische Sensor kann, wie oben beschrieben, eine Kamera umfassen. In einer besonders bevorzugten Ausführungsform ist der optische Sensor als eine Lichtschranke ausgestaltet. Für diesen Zweck kann der optische Sensor eine Anordnung von Spiegeln sowie einen Sender und einen Empfänger umfassen. Der Sender ist vorzugsweise dazu ausgebildet, einen gebündelten Lichtstrahl mit einer vorbestimmten Frequenz und/oder einer vorbestimmten Intensität zu emittieren. Der Empfänger kann entsprechend dazu ausgebildet sein, eine Intensität eines ausgesendeten Lichtstrahls zu messen. Die Anordnung von Spiegeln kann dazu ausgebildet sein, den Lichtstrahl entlang einer Oberfläche des Vorhangs von dem Sender zu dem Empfänger zu leiten. Beispielsweise kann der Lichtstrahl so nahe entlang der Oberfläche der Mehrzahl von Streifenelementen geführt sein, dass ein Abweichen des Vorhangs von der Schirmungskonfiguration zu einer Abschwächung oder Unterbrechung des Lichtstrahls führt, welche mittels des Empfängers detektiert werden kann. Es ist vorstellbar, dass ein entsprechender optischer Sensor auf beiden Seiten des Vorhangs installiert ist, um ein Hervorstehen eines Streifenelements von einer im Wesentlichen planaren Oberfläche des Vorhangs und/oder ein Verheddern bzw. Verwinden eines Streifenelements mit einer hohen Genauigkeit detektieren zu können.

Durch das Verwenden einer optisch basierten Messtechnik kann eine mechanische Verbindung des zumindest einen Sensors mit einzelnen Streifenelementen auf vorteilhafte Weise vermieden werden. Dadurch lässt sich eine Beweglichkeit einzelner Streifenelemente vorteilhaft erhöhen.

In einer Ausführungsform weist die erfindungsgemäße Schirmkabine eine Lüftungsanlage auf, welche dazu ausgebildet ist, ein Überführen des Vorhangs von einer Durchgangskonfiguration in die Schirmungskonfiguration mittels eines Luftstroms zu unterstützen. Es ist vorstellbar, dass die Lüftungsanlage dazu ausgebildet ist, den Luftstrom in vertikaler Weise annähernd parallel zu einer Oberfläche der Mehrzahl von Streifenelementen zu führen. Ein paralleles Ausrichten der Mehrzahl von Streifenelementen kann durch Bereitstellen des Luftstroms vorteilhaft unterstützt werden. Dadurch kann eine Notwendigkeit eines manuellen Eingreifens bzw. einer manuellen Korrektur durch den Nutzer vorteilhaft reduziert oder vermieden werden.

Das erfindungsgemäße Magnetresonanzsystem mit einer Magnetresonanzvorrichtung und einer Schirmkabine gemäß einer oben beschriebenen Ausführungsform weist eine Steuereinheit auf, wobei die Steuereinheit eine Signalverbindung mit dem zumindest einen Sensor aufweist und dazu ausgebildet ist, eine Magnetresonanzmessung in Abhängigkeit des Signals des zumindest einen Sensors freizugeben.

Die Steuereinheit und der zumindest eine Sensor können mittels einer kabelgebundenen oder kabellosen Verbindung miteinander verbunden sein. Die Steuereinheit kann eine Recheneinheit aufweisen, welche zu einer Verarbeitung des Signals des zumindest einen Sensors ausgebildet ist. Die Recheneinheit und/oder die Steuereinheit sind insbesondere dazu ausgebildet, ein Vorliegen einer Schirmungskonfiguration in Abhängigkeit des Signals des zumindest einen Sensors zu überwachen. Es ist ebenso vorstellbar, dass die Recheneinheit und/oder die Steuereinheit dazu ausgebildet sind, ein Abweichen von einer Schirmungskonfiguration in Abhängigkeit des Signals des zumindest einen Sensors zu bestimmen.

Durch die Möglichkeit eines Überwachens der Schirmungskonfiguration des Vorhangs kann ein Durchführen einer Magnetresonanzmessung bei unzureichender Schirmung des Untersuchungsraums auf vorteilhafte Weise verhindert werden.

In einer Ausführungsform des erfindungsgemäßen Magnetresonanzsystems weist die Schirmkabine ferner eine Tür auf, welche dazu ausgebildet ist, in einer Schirmungsstellung eine Schirmung vor einem elektromagnetischen Feld bereitzustellen. Die Tür kann eine konventionelle Tür eines Untersuchungsraums für ein Magnetresonanzsystem darstellen. Die Tür kann insbesondere dazu ausgebildet sein, elektromagnetische Felder in der Schirmungsstellung abzuschirmen. Es ist vorstellbar, dass der erfindungsgemäße Vorhang zusätzlich zu der konventionellen Tür in der Öffnung der Schirmungskabine installiert ist. Dies hat den Vorteil, dass die Tür während der Vorbereitung einer Magnetresonanzmessung und/oder der Durchführung geeigneter Magnetresonanzmessungen geöffnet bleiben kann, um ein Passieren für den Nutzer zu vereinfachen. Weiterhin kann die Tür während sensibler Magnetresonanzmessungen geschlossen werden, um eine für die Magnetresonanzmessung erforderliche Schirmungswirkung bereitzustellen.

Die Steuereinheit ist dazu ausgebildet, die Schirmungsstellung der Tür zu überwachen. Die Tür kann hierfür einen Endschalter, wie z. B. einen elektrischen Kontakt, einen optischen Sensor oder einen vergleichbaren Sensor, aufweisen, welcher einen geschlossenen Zustand der Tür mittels eines vorbestimmten Signals anzeigt.

Die Steuereinheit ist weiterhin dazu ausgebildet, ein Durchführen der Magnetresonanzmessung in Abhängigkeit eines Parameters der Magnetresonanzmessung und des Signals des zumindest einen Sensors bei einem Abweichen der Tür von der Schirmungsstellung freizugeben. Der Parameter der Magnetresonanzmessung umfasst einen Hinweis über eine Zulässigkeit einer Durchführung der Magnetresonanzmessung bei einem Abweichen der Tür von der Schirmungsstellung. Das Freigeben von Magnetresonanzmessungen kann insbesondere selektiv erfolgen. Ein Parametersatz bzw. eine Bildgebungssequenz einer Magnetresonanzmessung kann beispielsweise einen ersten Parameter aufweisen, welcher eine Eignung zu einer Durchführung der Magnetresonanzmessung bei geöffneter Tür und bei Vorliegen des Vorhangs in der Schirmungskonfiguration angibt. Der erste Parameter kann beispielsweise ein binärer Parameter sein (ein solcher Parameter kann z. B. den Wert "0" oder "1" verkörpern). Der erste Parameter kann aber auch von weiteren Parametern des Parametersatzes oder einem Signal des zumindest einen Sensors und/oder Endschalters abhängen. Weist der erste Parameter beispielsweise den Wert "1" auf, darf eine Magnetresonanzmessung bei geöffneter Tür und bei Vorliegen des Vorhangs in der Schirmungskonfiguration durchgeführt werden. Weist der erste Parameter dagegen den Wert "0" auf, muss die Tür der Schirmkabine für das Durchführen der Magnetresonanzmessung geschlossen sein.

Mittels der Signalverbindung mit dem zumindest einen Sensor und dem Endschalter der Tür kann die Steuereinheit einen Schirmungszustand der Schirmkabine ermitteln und ein Durchführen einer Magnetresonanzmessung entsprechend freigeben oder verhindern. Beispielsweise kann die Steuereinheit dazu ausgebildet sein, ein Starten einer Magnetresonanzmessung zu verhindern, wenn ein Durchführen der Magnetresonanzmessung bei geöffneter Tür erlaubt ist, aber der Vorhang von der Schirmungskonfiguration abweicht. In einem weiteren Beispiel kann ein Abweichen des Vorhangs von der Schirmungskonfiguration unerheblich für das Ausführen der Magnetresonanzmessung sein, wenn die Tür der Schirmungskabine geschlossen ist. Die Steuereinheit kann demnach dazu ausgebildet sein, ein Durchführen einer Magnetresonanzmessung in Abhängigkeit eines Vorliegens der Schirmungskonfiguration des Vorhangs, eines Zustands der Tür der Schirmkabine und/oder eines Parametersatzes der jeweiligen Magnetresonanzmessung freizugeben.

Durch das Bereitstellen des erfindungsgemäßen Magnetresonanzsystems mit der Steuereinheit lässt sich ein Durchführen einer Magnetresonanzmessung bei einem unerwünschten Schirmungszustand der Schirmkabine vorteilhaft vermeiden. Ferner können Arbeitsabläufe eines Nutzers eines Magnetresonanzsystems durch Bereitstellen einer erfindungsgemäßen Steuereinheit und einer erfindungsgemäßen Schirmkabine vereinfacht und/oder effizienter gestaltet werden. Insbesondere das Durchführen sogenannter Localizer-Messungen und/oder unspezifischer Ganzkörpermessungen (z. B. mittels FastView), lassen sich durch Bereitstellen eines erfindungsgemäßen Vorhangs aufgrund geringerer Schirmungserfordernisse auch bei geöffneter Tür durchführen und somit vorteilhaft vereinfachen. Das erfindungsgemäße Magnetresonanzsystem teilt die Vorteile des erfindungsgemäßen Vorhangs und der erfindungsgemäßen Schirmkabine gemäß einer oben beschriebenen Ausführungsform.

Weitere Vorteile und Einzelheiten ergeben sich aus der nachfolgenden Beschreibung von Ausführungsbeispielen in Verbindung mit den Zeichnungen. Es zeigen in Prinzipdarstellung:
- Fig. 1: eine schematische Darstellung einer Ausführungsform eines erfindungsgemäßen Magnetresonanzsystems mit einer erfindungsgemäßen Schirmkabine,
- Fig. 2: eine schematische Darstellung einer Ausführungsform eines erfindungsgemäßen Vorhangs,
- Fig. 3: eine schematische Darstellung einer Ausführungsform eines erfindungsgemäßen Vorhangs,
- Fig. 4: eine schematische Darstellung einer Ausführungsform eines erfindungsgemäßen Vorhangs,
- Fig. 5: eine schematische Darstellung einer Ausführungsform eines erfindungsgemäßen Vorhangs,
- Fig. 6: eine schematische Darstellung einer Ausführungsform eines erfindungsgemäßen Vorhangs,
- Fig. 7: eine schematische Darstellung einer Ausführungsform eines erfindungsgemäßen Vorhangs,
- Fig. 8: eine schematische Darstellung einer Ausführungsform eines erfindungsgemäßen Vorhangs.

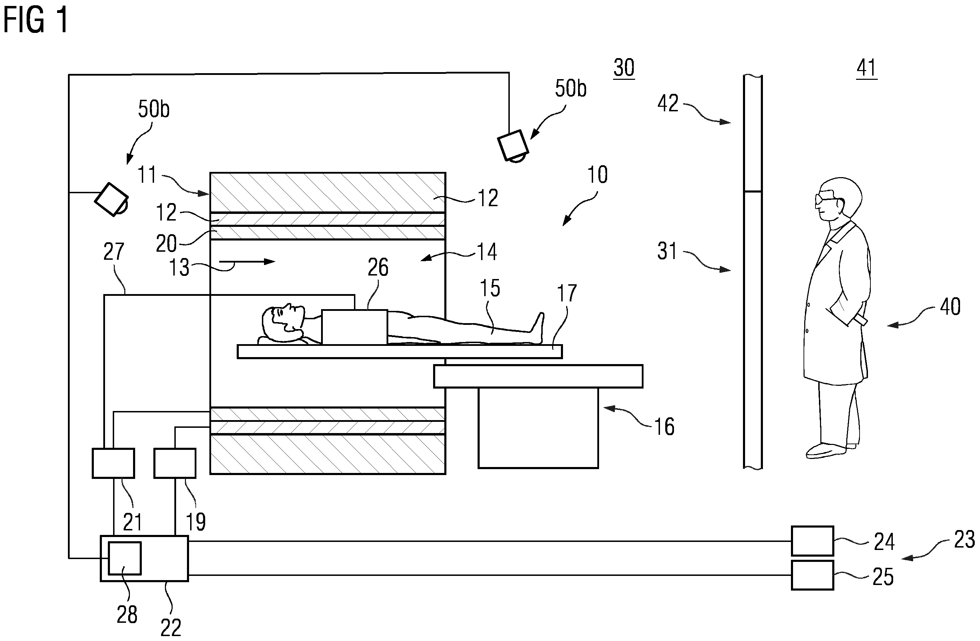

In Fig. 1 ist eine mögliche Ausführungsform eines erfindungsgemäßen Magnetresonanzsystems schematisch dargestellt. Das Magnetresonanzsystem umfasst eine Magnetresonanzvorrichtung 10 mit einer Magneteinheit 11, welche z. B. einen Permanentmagneten, einen Elektromagneten oder einen supraleitenden Hauptmagneten 12 zur Erzeugung eines starken und insbesondere homogenen Grundmagnetfelds 13 (B0-Magnetfeld) aufweist. Zudem umfasst die Magnetresonanzvorrichtung 10 einen Patientenaufnahmebereich 14 zu einer Aufnahme eines Patienten 15. Der Patientenaufnahmebereich 14 ist in dem vorliegenden Ausführungsbeispiel zylinderförmig ausgebildet und in einer Umfangsrichtung von der Magneteinheit 11 umgeben. Selbstverständlich sind jedoch auch von diesem Beispiel abweichende Ausbildungen des Patientenaufnahmebereichs 14 vorstellbar. Die Magnetresonanzvorrichtung 10 ist vorliegend in einer Schirmkabine 42 positioniert, welche die Magnetresonanzvorrichtung außenumfänglich umschließt und vorliegend nur teilweise dargestellt ist.

Der Patient 15 kann mittels einer Patientenlagerungsvorrichtung 16 der Magnetresonanzvorrichtung 10 in dem Patientenaufnahmebereich 14 positioniert werden. Die Patientenlagerungsvorrichtung 16 weist hierfür einen innerhalb des Patientenaufnahmebereichs 14 bewegbar ausgestalteten Patiententisch 17 auf. Die Magneteinheit 11 weist weiterhin eine Gradientenspule 18 zum Erzeugen von magnetischen Gradientenfeldern auf, welche für eine Ortskodierung während einer Magnetresonanzmessung verwendet wird. Die Gradientenspule 18 wird mittels einer Gradientensteuereinheit 19 der Magnetresonanzvorrichtung 10 angesteuert. Die Magneteinheit 11 kann weiterhin eine Hochfrequenzantenne umfassen, welche im vorliegenden Ausführungsbeispiel als fest in die Magnetresonanzvorrichtung 10 integrierte Körperspule 20 ausgebildet ist. Die Körperspule 20 ist zu einer Anregung von Atomkernen ausgelegt, die sich in dem von dem Hauptmagneten 12 erzeugten Grundmagnetfeld 13 befinden. Die Körperspule 20 wird von einer Hochfrequenzeinheit 21 der Magnetresonanzvorrichtung 10 angesteuert und strahlt hochfrequente Signale in einen Untersuchungsraum ein, der im Wesentlichen von einem Patientenaufnahmebereich 14 der Magnetresonanzvorrichtung 10 gebildet ist. Die Körperspule 20 kann weiterhin auch zu einem Empfangen von Magnetresonanzsignalen ausgebildet sein.

Für eine Steuerung des Hauptmagneten 12, der Gradientensteuereinheit 19 und der Hochfrequenzeinheit 21 weist die Magnetresonanzvorrichtung 10 eine Steuereinheit 22 auf. Die Steuereinheit 22 ist dazu ausgebildet eine Durchführung einer Sequenz, wie z. B. einer bildgebenden Gradientenechosequenz, einer TSE-Sequenz oder einer UTE-Sequenz, zu steuern. Zudem umfasst die Steuereinheit 22 eine Recheneinheit 28 zu einer Auswertung von digitalisierten Magnetresonanzsignalen, die während einer Magnetresonanzmessung erfasst werden.

Des Weiteren umfasst die Magnetresonanzvorrichtung 10 eine Benutzerschnittstelle 23, welche eine Signalverbindung mit der Steuereinheit 22 aufweist. Die Benutzerschnittstelle ist vorzugsweise in einem Kontrollraum 41 untergebracht, welcher an den Untersuchungsraum 30 bzw. die Schirmkabine 42 mit der Magnetresonanzvorrichtung 10 angrenzt. Steuerinformationen, wie beispielsweise Bildgebungsparameter und rekonstruierte Magnetresonanzbilder, können auf einer Anzeigeeinheit 24, beispielsweise auf zumindest einem Monitor der Benutzerschnittstelle 23, für einen Nutzer 40 angezeigt werden. Weiterhin weist die Benutzerschnittstelle 23 eine Eingabeeinheit 25 auf, mittels der Parameter einer Magnetresonanzbildgebung von dem Nutzer 40 eingegeben werden können.

Ferner weist die Magnetresonanzvorrichtung 10 eine Lokalspule 26 auf, welche vorliegend an einem Oberkörper des Patienten 15 positioniert ist und Magnetresonanzsignale aus einem Thorax-Volumen an die Magnetresonanzvorrichtung 10 überträgt. Die Lokalspule 26 weist vorzugsweise eine elektrische Anschlussleitung 27 auf, welche eine Signalverbindung mit der Hochfrequenzeinheit 21 und der Steuereinheit 22 bereitstellt. Die Lokalspule 26 kann aber auch mittels einer drahtlosen Signalverbindung mit der Magnetresonanzvorrichtung 10 verbunden sein. Ebenso wie die Körperspule 20 kann auch die Lokalspule 26 zu einer Anregung von Atomkernen und zu einem Empfangen von Magnetresonanzsignalen ausgebildet sein.

In dem in Fig. 1 gezeigten Beispiel weist das Magnetresonanzsystem weiterhin zwei Kameras 50a und 50b auf, welche für die Unterstützung eines Arbeitsablaufs der Magnetresonanzmessung ausgebildet sind. Mögliche Beispiele einer solchen Unterstützung umfassen eine Positionierung von Lokalspulen 26 an dem Patienten 15, eine Positionierung des Patienten 15 relativ zu dem Patiententisch 17, aber auch eine Gesichtserkennung des Patienten 15 während einer Magnetresonanzmessung. Zumindest eine Kamera 50b kann dabei auch auf einen Eingang zu dem Untersuchungsraum 30 gerichtet sein und Bilddaten des Vorhangs 31 erfassen. Es ist vorstellbar, dass die Bilddaten der Kamera 50b mittels einer Signalverbindung an die Recheneinheit 28 der Steuereinheit 22 übermittelt werden. Die Recheneinheit 28 kann entsprechend dazu ausgebildet sein, die Bilddaten zu verarbeiten, um eine Schirmungskonfiguration des Vorhangs 31 zu überwachen. Die Recheneinheit 28 ist insbesondere dazu ausgebildet, ausgewählte Magnetresonanzmessungen freizugeben, wenn sich der Vorhang 31 in einer Schirmungskonfiguration befindet und/oder ein Ausführen einer Magnetresonanzmessung zu verhindern, wenn die aktuelle Konfiguration des Vorhangs 31 von der Schirmungskonfiguration abweicht.

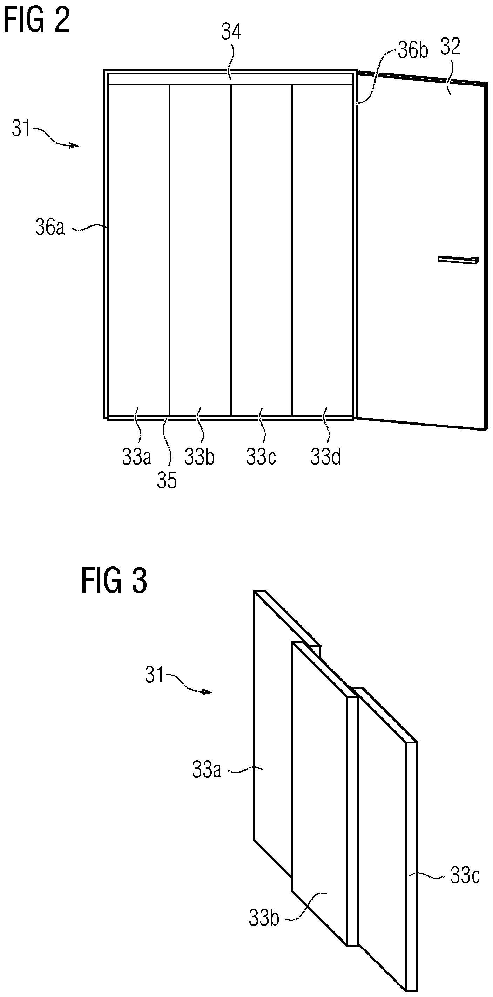

Es ist vorstellbar, dass ausgewählte Magnetresonanzmessungen einen Parameter aufweisen, welcher auf die Möglichkeit einer Ausführung von Magnetresonanzmessungen bei geöffneter Tür 32 (siehe Fig. 2) und bei Vorliegen des Vorhangs 31 in der Schirmungskonfiguration hinweist oder eine entsprechende Kodierung bereitstellt. Mittels der Signalverbindung mit der Kamera 50b oder einem anderen Sensor 50 kann die Steuereinheit einen Schirmungszustand der Schirmkabine 32 ermitteln und ein Durchführen einer Magnetresonanzmessung entsprechend freigeben oder verhindern. Hierbei kann insbesondere auch eine Schirmungsstellung einer zusätzlich vorhandenen Tür 32 überwacht (z. B. mittels der Kamera 50b, eines elektrischen Kontakts und/oder eines Endschalters) und bei der Freigabe oder Durchführung einer Magnetresonanzmessung berücksichtigt werden.

Das in Fig. 1 dargestellte Magnetresonanzsystem kann selbstverständlich weitere Komponenten umfassen, welche Magnetresonanzsystem üblicherweise aufweisen. Es ist ebenso vorstellbar, dass die Magnetresonanzvorrichtung 10 statt des zylinderförmigen Aufbaus einen C-förmigen, einen dreieckigen oder einen asymmetrischen Aufbau der Magnetfeld-erzeugenden Komponenten aufweist. Die Magnetresonanzvorrichtung 10 kann insbesondere als ein dedizierter Scanner für die Untersuchung bestimmter Körperregionen, wie z. B. ein Kopfscanner, ein Dentalscanner, ein Scanner für Extremitäten oder dergleichen, ausgebildet sein. Die folgenden Figuren geben einen Überblick über mögliche Ausgestaltungsformen des erfindungsgemäßen Vorhangs 31.

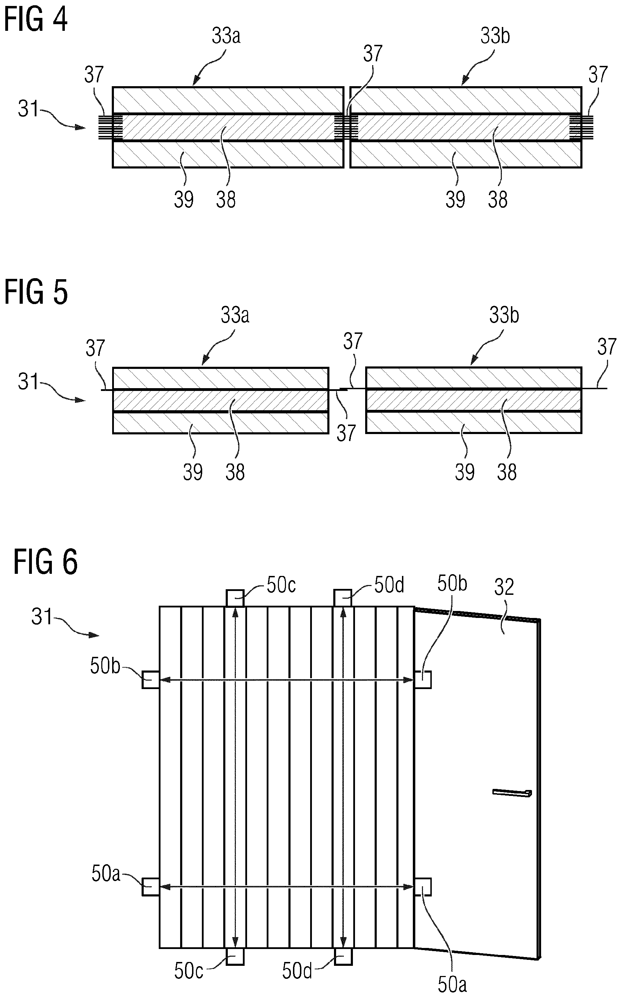

Fig. 2 zeigt schematisch eine Ausführungsform eines erfindungsgemäßen Vorhangs 31. In dem gezeigten Beispiel ist der Vorhang 31 zusätzlich zu einer Tür 32 in einem Zugangsbereich der Schirmungskabine 42 bzw. des Untersuchungsraums 30 integriert. Der Vorhang 31 weist vorliegend vier Streifenelemente 33a, 33b, 33c und 33d (33a-d) auf. Die Streifenelemente 33a-d sind mechanisch mit einem Halteelement 34 verbunden und befinden sich vorliegend in der Schirmungskonfiguration. Die Streifenelemente 33a-d sind im Wesentlichen parallel zueinander ausgerichtet und weisen einen elektrischen Kontakt mit dem Halteelement 34 und der Bodenleiste 35 auf. Die beiden äußeren Streifenelemente 33a und 33d weisen ferner einen elektrischen Kontakt mit den Rahmenelementen 36a und 36b auf. Der elektrische Kontakt zwischen den Streifenelementen 33a-33d, aber auch der Bodenleiste und/oder dem Rahmenelement kann beispielsweise mittels geeigneter Kontaktelemente (siehe Fig. 5 und 6) und/oder durch Überlappen (siehe Fig. 3) realisiert werden. Vorzugsweise wird der elektrische Kontakt der Streifenelemente 33a-d mit dem Halteelement 34 mittels der mechanischen Verbindung erreicht. Das Halteelement 34, die Rahmenelemente 36a und 36b und/oder die Bodenleiste 35 können elektrisch mit einem geeigneten Bezugspotenzial verbunden sein. Das Halteelement 34 ist insbesondere dazu ausgebildet, die Streifenelemente 33a-d in der Schirmungskonfiguration zu halten. Da die Streifenelemente 33a-d mechanisch unverbunden sind, ist der Nutzer 40 dazu imstande, die Streifenelemente 33a-d unabhängig voneinander gegenüber dem Halteelement 34 auszulenken und in eine Durchgangskonfiguration zu überführen (nicht gezeigt). Die Streifenelemente 33a-d können ferner mit Gewichten (nicht gezeigt) beschwert sein, um ein Zurückkehren in die Schirmungskonfiguration zu gewährleisten.

Fig. 3 zeigt schematisch eine mögliche Ausführungsform des erfindungsgemäßen Vorhangs 31. In dem vorliegenden Beispiel sind die Streifenelemente 33a-c des Vorhangs 31 teilweise überlappend angeordnet. Durch das Überlappen der Streifenelemente 33a-d wird eine Kontaktfläche zwischen den Streifenelementen 33a-c bereitgestellt, welche ein Leiten eines elektrischen Stroms zwischen den Streifenelementen 33a-c, insbesondere auch in einer horizontalen Richtung, ermöglicht. Die Streifenelemente 33a-c können eine Schutzschicht (siehe

Fig. 4) aufweisen, welche elektrisch leitend ist und/oder an den überlappenden Flächen der Streifenelemente 33a-c eine Aussparung aufweist. Die Streifenelemente 33a-c können aber auch aus einem Edelstahlgewebe, einem Edelstahlgeflecht oder aus Edelstahlkettengliedern gefertigt sein, welche keine zusätzliche Schutzschicht aufweisen. Es ist ebenso vorstellbar, dass die Streifenelemente 33a-c im Wesentlichen nebeneinander, statt teilweise überlappend, angeordnet sind. Es ist weiterhin vorstellbar, dass die Streifenelemente 33a-c hintereinander überlappend, anstelle abwechselnd überlappend, angeordnet sind.

Fig. 4 zeigt schematisch eine Querschnittsansicht zweier Streifenelemente 33a und 33b des erfindungsgemäßen Vorhangs 31. In dem vorliegenden Beispiel ist die elektrisch leitfähige Schicht 38 der Streifenelemente 33a und 33b von einer flexiblen Schutzschicht 39 umgeben. Die Schutzschicht 39 des Streifenelements 33a weist an einer dem Streifenelement 33b zugewandten Seite eine Öffnung oder Aussparung auf, welche ein elektrisches Verbinden der elektrisch leitfähigen Schichten 38 der Streifenelemente 33a und 33b ermöglicht.

In der vorliegenden Darstellung weist der Vorhang 31 eine Mehrzahl von Kontaktelementen 37 auf, welche die elektrisch leitfähige Schichten 38 der Streifenelemente 33a und 33b elektrisch verbindet. Die Kontaktelemente 37 sind beispielhaft als Bürsten ausgeführt. Vorzugsweise sind die außenliegenden Streifenelemente 33a und 33d (siehe Fig. 2) mittels Kontaktelementen 37 elektrisch mit den Rahmenelementen 36a und 36b sowie der Bodenleiste 35 verbunden.

In alternativen Ausführungsformen kann auch auf Kontaktelemente 37 verzichtet werden. Die Schirmungswirkung des Vorhangs kann in diesem Fall im Wesentlichen durch Reflektion und/oder Absorption erreicht werden.

Fig. 5 zeigt eine alternative Ausführungsform des erfindungsgemäßen Vorhangs 31. Im Gegensatz zu Fig. 4 sind die Kontaktelemente 37 vorliegend als flache Folien oder Gewebeschichten ausgeführt. Die Folien, Platten oder Gewebeschichten 37 können zwischen der Schutzschicht 39 und der elektrisch leitfähigen Schicht 38 angeordnet und elektrisch mit der elektrisch leitfähigen Schicht 38 verbunden sein. Vorzugweise weisen die Kontaktelemente 37 der Streifenelemente 33a und 33b in der Schirmungskonfiguration einen Überlappungsbereich auf, welcher eine elektrische Verbindung der elektrisch leitfähigen Schichten 38 der Streifenelemente 33a und 33b ermöglicht. Selbstverständlich sind Abmessungen und Größenverhältnisse der gezeigten Komponenten als beispielhaft zu verstehen und können in Abhängigkeit verwendeter Materialien und Nutzerpräferenzen deutlich variieren.

Fig. 6 zeigt eine Ausführungsform, bei welcher der erfindungsgemäße Vorhang 31 Widerstandssensoren 50a, 50b, 50c und 50d (50a-d) aufweist. Vorzugsweise weist jeder der Widerstandssensoren 50a-d eine Quelle und einen Empfänger auf, welche vorzugsweise an gegenüberliegenden Seiten des Vorhangs 31 angeordnet sind. Die Quellen können dabei insbesondere (Konstant-)Stromquellen darstellen, während die Empfänger als Spannungssensoren ausgestaltet sind. Es ist vorstellbar, dass der Vorhang 31 eine geringere Anzahl von Quellen als Empfänger aufweist. In einer Ausführungsform weist der Vorhang 31 genau eine Quelle und einen oder mehrere Empfänger auf.

In der in Fig. 6 gezeigten Ausführungsform sind die Widerstandssensoren 50a-d dazu ausgebildet, den elektrischen Widerstand (bzw. Spannungsabfall) der elektrisch leitfähigen Schicht 38 des Vorhangs 31 entlang vier Bezugsstrecken (siehe Pfeile) zu ermitteln. Vorzugsweise wird in der Schirmungskonfiguration des Vorhangs 31 einmalig oder in regelmäßigen Abständen eine Referenzmessung des Widerstands (bzw. des Spannungsabfalls) durchgeführt, welche von der Steuereinheit 22 des Magnetresonanzsystems als Referenz herangezogen wird. Liegt eine Abweichung aktuell gemessener Widerstände (oder Spannungsabfälle) von der Referenz vor, so kann ein Abweichen des Vorhangs 31 von der Schirmungskonfiguration ermittelt und ein Ausführen einer Magnetresonanzmessung verhindert werden.

Alternativ zu der in Fig. 6 dargestellten Variante kann die Widerstandsmessung auch als eine Vier-Punkt-Messung oder eine Van-der-Pauw-Messung implementiert sein. Dabei wird anstelle von einzelnen Widerständen entlang von Bezugsstrecken zumindest ein Flächenwiderstand der elektrisch leitfähigen Schicht 38 der Mehrzahl von Streifenelementen 33 ermittelt und zu einem Bestimmen einer aktuellen Konfiguration des Vorhangs 31 herangezogen.

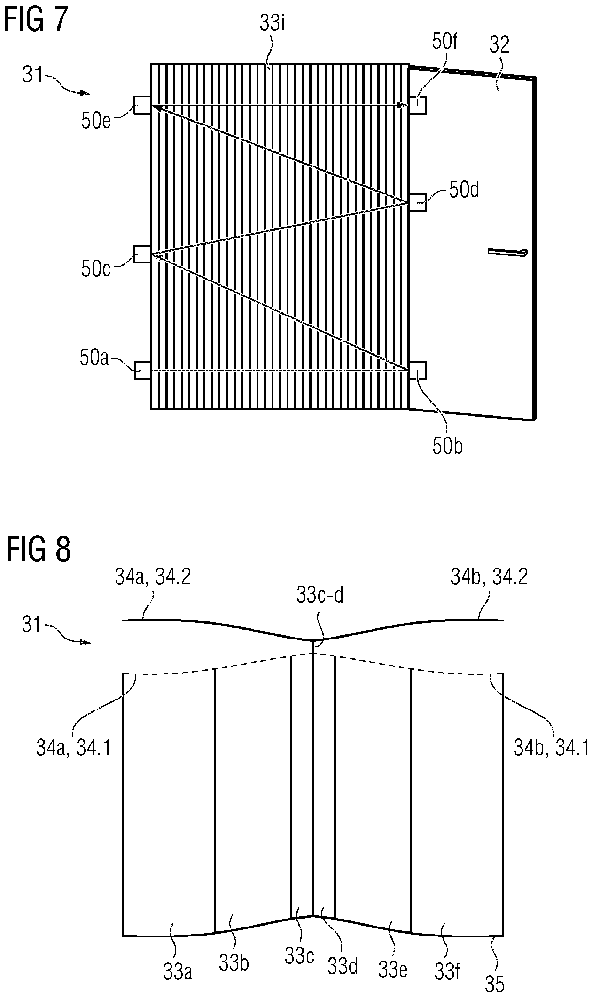

Fig. 7 zeigt eine Ausführungsform des erfindungsgemäßen Vorhangs, bei welcher eine Lichtschranke 50 für das Ermitteln der Schirmungskonfiguration verwendet wird. Der Vorhang 31 weist hierfür einen Sender 50a auf, welcher dazu ausgebildet ist, einen gebündelten Lichtstrahl auszusenden. Der Lichtstrahl wird mittels der Spiegel 50b, 50c, 50d und 50e mehrfach umgeleitet und schließlich an einen Empfänger 50f übertragen. Der Lichtstrahl wird vorzugsweise direkt an einer Oberfläche der Mehrzahl von Streifenelementen 33 entlanggeleitet, sodass ein Verwinden, ein Verheddern und/oder ein Hervorstehen eines Streifenelements 33i von einer im Wesentlichen planaren Frontfläche der Mehrzahl von Streifenelementen 33 zu einem Abschwächen oder Unterbrechen des Lichtstrahls führt. Ein Abweichen des Vorhangs 31 von der Schirmungskonfiguration kann entsprechend in Abhängigkeit eines Signals des Empfängers 50f detektiert werden. Beispielsweise wird das Signal dabei in Abhängigkeit einer Intensität und/oder einer Unterbrechung des Lichtstrahls bestimmt. Vorzugsweise weist die erfindungsgemäße Schirmkabine 42 eine erste Lichtschranke auf der Seite des Untersuchungsraums 30 und eine zweite Lichtschranke auf der Seite eines angrenzenden Raums (z. B. Kontrollraum 41) auf. Die Lichtschranke 50 kann eine beliebige Anzahl von Spiegelelementen, aber auch eine Mehrzahl von Sendern und Empfängern aufweisen.

In den Ausführungsformen der Fig. 1, 6 und 7 ist der Sensor 50 vorzugsweise mittels einer kabelgebundenen oder kabellosen Signalverbindung mit der Steuereinheit 22 und/oder der Recheneinheit 28 verbunden. Es ist jedoch ebenso vorstellbar, dass der Sensor 50 bereits eine Recheneinheit und/oder Steuereinheit aufweist, um das Signal des Sensors 50 zu verarbeiten und/oder zu konditionieren, bevor es mittels einer geeigneten Schnittstelle an die Recheneinheit 28 und/oder die Steuereinheit 22 der Magnetresonanzvorrichtung 10 übertragen wird.

In der in Fig. 8 gezeigten Ausführungsform weist das Halteelement 34a eine geschwungene Form auf. Das Halteelement 34a ist dabei im Wesentlichen parallel zu dem Boden und/oder der Decke (nicht gezeigt) des Untersuchungsraums 30 ausgerichtet. Der Vorhang 31 weist vorliegend die Streifenelemente 33a, 33b, 33c, 33d, 33e und 33f (33a-f) auf, welche eine identische oder unterschiedliche Breitenabmessung aufweisen können. Insbesondere weist der Vorhang 31 einen Kontaktbereich 33c-d auf, welcher durch ein Überlappen oder ein aneinander Anliegen der Streifenelemente 33c und 33d gekennzeichnet ist. Der Kontaktbereich 33c-d stellt bevorzugt einen Durchtrittsbereich für den Nutzer 40 dar, welcher die Streifenelemente 33a-c und die Streifenelemente 33d-f beim Durchtreten manuell in unterschiedliche Richtungen auslenken kann.

Das Streifenelement kann einteilig ausgestaltet sein oder wie in Fig. 8 gezeigt, aus mehreren Halteelementen 34a und 34b zusammengesetzt sein. In dem dargestellten Beispiel weisen die Halteelemente 34a und 34b eine im Wesentlichen trichterförmige, U-förmige oder V-förmige Querschnittsform auf und stehen sich an einem Scheitelpunkt bzw. einer Scheitelfläche, welche durch den Kontaktbereich 33c-d charakterisiert ist, gegenüber. Das Halteelement 34, welches sich aus den Halteelementen 34a und 34b ergibt, kann somit eine Querschnittsform aufweisen, welche an eine Sanduhr erinnert.

Alternativ kann das Halteelement 34 jedoch auch zwei Halteelemente 34.1 und 34.2 aufweisen. Die Querschnittsform des Halteelements 34.1 kann im Wesentlichen einer Querschnittskontur des Vorhangs 31 entlang einer Schnittebene, welche im Wesentlichen horizontal oder parallel zu dem Boden und/oder der Decke des Untersuchungsraums 30 ausgerichtet ist, entsprechen (gestrichelte Linie). Das Halteelement 34.1 kann beispielsweise auf einer dem Untersuchungsraum 30 zugewandten Seite des Vorhangs 31 angeordnet sein, während das Halteelement 34.2 auf der dem Kontrollraum 41 zugewandten Seite angeordnet ist.

Obwohl die Erfindung im Detail durch die bevorzugten Ausführungsbeispiele näher illustriert und beschrieben wurde, so ist die Erfindung dennoch nicht durch die offenbarten Beispiele eingeschränkt und andere Variationen können vom Fachmann hieraus abgeleitet werden, ohne den Schutzumfang der Erfindung zu verlassen.

## Patentansprüche

1. Vorhang (31) zur Schirmung eines elektromagnetischen Felds, aufweisend eine Mehrzahl von Streifenelementen (33), wobei ein erstes Streifenelement und ein zweites Streifenelement der Mehrzahl von Streifenelementen (33) eine elektrisch leitfähige Schicht (38) aufweisen und wobei die elektrisch leitfähige Schicht (38) des ersten Streifenelements in einer Schirmungskonfiguration des Vorhangs (31) elektrisch mit der elektrisch leitfähigen Schicht (38) des zweiten Streifenelements und/oder einem elektrischen Anschluss für ein Bezugspotenzial verbunden ist, wobei die Mehrzahl von Streifenelementen (33) veränderlich gegeneinander positionierbar sind, **dadurch gekennzeichnet, dass** das erste Streifenelement und das zweite Streifenelement mechanisch und elektrisch voneinander trennbar sind, wobei das erste Streifenelement und das zweite Streifenelement aneinander anliegen und/oder einander berühren, ohne sich wesentlich gegeneinander in einer relativen Bewegung einzuschränken.

2. Vorhang (31) nach Anspruch 1, wobei die elektrisch leitfähige Schicht (38) als eine Beschichtung, eine Folie, ein Draht, ein Drahtgeflecht, eine Anordnung von Metallgliedern und/oder eine Karbonmatrix ausgestaltet ist.

3. Vorhang (31) nach einem der Ansprüche 1 oder 2, wobei die elektrisch leitfähige Schicht (38) eine Schutzschicht (39) aufweist, welche die elektrisch leitfähige Schicht (38) zumindest teilweise umschließt, wobei die Schutzschicht (39) dazu ausgebildet ist,
• einen Berührschutz zu der elektrisch leitfähigen Schicht (38) bereitzustellen und/oder
• die elektrisch leitfähige Schicht (38) vor einem äußeren Einfluss zu schützen.

4. Vorhang (31) nach Anspruch 3, wobei die Mehrzahl von Streifenelementen und/oder die Schutzschicht (39) ein flexibles Material aufweisen, welches dazu ausgebildet ist, bei einem relativen Positionieren des ersten Streifenelements gegenüber dem zweiten Streifenelement reversibel verformt zu werden.

5. Vorhang (31) nach einem der vorhergehenden Ansprüche, wobei die elektrisch leitfähige Schicht (38) des ersten Streifenelements mittels eines Kontaktelements (37) elektrisch mit der elektrisch leitfähigen Schicht (38) des zweiten Streifenelements und/oder dem Anschluss für das Bezugspotenzial verbunden ist.

6. Vorhang (31) nach Anspruch 5, wobei das Kontaktelement (37) als ein Kamm, eine Bürste, ein Geflecht und/oder ein Gewebe ausgestaltet ist.

7. Vorhang (31) nach einem der vorhergehenden Ansprüche, wobei der Vorhang (31) ein Halteelement (34) umfasst, welches mechanisch mit dem ersten Streifenelement und dem zweiten Streifenelement verbunden ist und dazu ausgebildet ist, das erste Streifenelement und das zweite Streifenelement in der Schirmungskonfiguration an einer Öffnung zu einem Untersuchungsraum (30) zu halten.

8. Vorhang (31) nach einem der vorhergehenden Ansprüche, wobei der Vorhang (31) einen elektrischen Kontakt zu dem Bezugspotenzial aufweist und wobei der Vorhang (31) dazu ausgebildet ist, einer Wirkung des elektromagnetischen Felds durch Ermöglichen eines Ausgleichstroms mit dem Bezugspotenzial entgegenzuwirken.

9. Vorhang (31) nach einem der vorhergehenden Ansprüche, wobei das erste Streifenelement elektrisch mit einem Rahmenelement (36) und/oder einer Bodenleiste (35) verbunden ist, wobei das Rahmenelement (36) und/oder die Bodenleiste (35) elektrisch mit dem Bezugspotenzial verbunden sind und wobei der Vorhang (31) dazu ausgebildet ist, einen elektrischen Strom an das Rahmenelement (36) und/oder die Bodenleiste (35) abzuleiten.

10. Schirmkabine (42) für eine Magnetresonanzvorrichtung (10), aufweisend eine Öffnung und einen Vorhang (31) zur Schirmung eines elektromagnetischen Felds, wobei der Vorhang (31) eine Mehrzahl von Streifenelementen (33) umfasst, wobei ein erstes Streifenelement und ein zweites Streifenelement der Mehrzahl von Streifenelementen (33) eine elektrisch leitfähige Schicht (38) aufweisen und wobei die elektrisch leitfähige Schicht (38) des ersten Streifenelements in einer Schirmungskonfiguration des Vorhangs (31) elektrisch mit einer elektrisch leitfähigen Schicht (38) des zweiten Streifenelements der Mehrzahl von Streifenelementen (33) und/oder einem Bezugspotenzial verbunden ist, wobei die Mehrzahl von Streifenelementen (33) entlang einer Haupterstreckungsrichtung veränderlich gegeneinander positionierbar sind und wobei der Vorhang (31) an der Öffnung der Schirmkabine (42) angeordnet ist und dazu ausgebildet ist, einen Zugang zu der Schirmkabine (42) zu ermöglichen.

11. Schirmkabine (42) nach Anspruch 10, aufweisend zumindest einen Sensor (50), welcher dazu ausgebildet ist, ein ordnungsgemäßes Vorliegen des Vorhangs (31) in der Schirmungskonfiguration zu ermitteln und ein Signal auszugeben, welches eine Information über das Vorliegen des Vorhangs (31) in der Schirmungskonfiguration enthält, wobei der zumindest eine Sensor (50) als ein Widerstandssensor ausgestaltet ist, welcher dazu ausgebildet ist, einen Widerstand, insbesondere einen Flächenwiderstand, der elektrisch leitfähigen Schicht (38) der Mehrzahl von Streifenelementen (33) zu ermitteln.

12. Schirmkabine (42) nach Anspruch 10, aufweisend zumindest einen Sensor (50), welcher dazu ausgebildet ist, ein ordnungsgemäßes Vorliegen des Vorhangs (31) in der Schirmungskonfiguration zu ermitteln und ein Signal auszugeben, welches eine Information über das Vorliegen des Vorhangs (31) in der Schirmungskonfiguration enthält, wobei der zumindest eine Sensor (50) als ein optischer Sensor ausgestaltet ist, welcher dazu ausgebildet ist, ein Abweichen des Vorhangs (31) von der Schirmungskonfiguration zu ermitteln.

13. Magnetresonanzsystem mit einer Magnetresonanzvorrichtung (10) und einer Schirmkabine (42) nach einem der Ansprüche 11 oder 12, aufweisend eine Steuereinheit (22), wobei die Steuereinheit (22) eine Signalverbindung mit dem zumindest einen Sensor (50) aufweist und dazu ausgebildet ist, eine Magnetresonanzmessung in Abhängigkeit des Signals des zumindest einen Sensors (50) freizugeben.

14. Magnetresonanzsystem nach Anspruch 13, wobei die Schirmkabine (42) ferner eine Tür (32) aufweist, welche dazu ausgebildet ist, in einer Schirmungsstellung eine Schirmung vor einem elektromagnetischen Feld bereitzustellen, wobei die Steuereinheit dazu ausgebildet ist, die Schirmungsstellung der Tür (32) zu überwachen und ein Durchführen der Magnetresonanzmessung in Abhängigkeit eines Parameters der Magnetresonanzmessung und des Signals des zumindest einen Sensors (50) bei einem Abweichen der Tür (32) von der Schirmungsstellung freizugeben, wobei der Parameter der Magnetresonanzmessung einen Hinweis über eine Zulässigkeit einer Durchführung der Magnetresonanzmessung bei einem Abweichen der Tür (32) von der Schirmungsstellung umfasst.
